# EUROPEAN PATENT APPLICATION

(11) **EP 3 276 651 A1**
(43) Date of publication of application: **31.01.2018**
(21) Application number: 16181774.7
(22) Date of filing: 28.07.2016
(51) Int. Cl.: H01J 37/32, C23C 16/27, C23C 16/458, H05H 1/46

(54) **METHOD FOR MANUFACTURING AN ANNULAR THIN FILM OF SYNTHETIC MATERIAL AND DEVICE FOR CARRYING OUT SAID METHOD**

(71) Applicant: NeoCoat SA, 2300 La Chaux-de-Fonds (CH)
(72) Inventor: Rats, David, 2000 Neuchâtel (CH); Naamoun, Medhi, CH-2000 Neuchâtel (CH); Provent, Christophe, 01170 Cessy (FR)
(74) Representative: Gevers SA

(57) **Abstract**

In the present invention a method is disclosed for producing synthetic material on a substrate by microwave plasma activated chemical vapor deposition. The method comprises the step of providing a microwave plasma reactor configured to provide a plasma having a toroidal shape. The reactor comprises a resonant cavity and a substrate holder arranged to hold, preferably, an annular shaped substrate or a plurality of substrates arranged in an annular configuration.

When the reactor is in operation, it forms a plasma which has a toroidal shape and is aligned and proximate to a substrate whereupon a ring of synthetic hard material is grown over the growth surface of the substrate.

The invention is also achieved by a plasma reactor that is configured to provide a plasma having a toroidal shape facing at least one substrate to be coated with an annular shaped hard material such as diamond.

## Description

### Field of invention

The present invention relates to a method to manufacture thin film annular hard materials and also to a microwave plasma generator for manufacturing thin films of hard materials, such as synthetic diamond and related materials.

### Background of invention

Diamond films possess a number of outstanding physical properties including extreme hardness, high thermal conductivity and wide-band optical transmission. This makes diamond in particular attractive for a number of applications.

Synthesis of thin films of hard materials such as diamond using chemical vapor deposition (CVD) techniques is well known and described in for example the Journal of Physics : Condensed matter, 21, 36 (2009) which gives an overview of diamond related technologies. An overview of CVD diamond deposition techniques and materials may be found in: R.S. Balmer et al,. "Chemical vapor deposition synthetic diamond: materials, technology and applications", J.Phys.; Condensed Matter, Vol.21, nr.36, 36422, (2009).

The deposition of polycrystalline diamond obtained with CVD technique is based on the principle of decomposing a gas mixture comprising a carbon and a hydrogen precursor. The activation in the gas phase is performed either by Hot Filament Chemical Vapor Deposition (HFCVD) or by means of a microwave plasma (Microwave Plasma Chemical Vapor Deposition, or MPCVD) or DC Arc Plasma.

Microwave plasma chemical vapor deposition (MPCVD) techniques present several advantages such as: no contamination from filaments, high atomic hydrogen concentration that allows obtaining well controlled microstructures and a high quality of the deposited diamond films.

In the last 20 years several types of MPCVD reactors have been proposed such as ones based on a quartz tube, a quartz bell jar and having a cylindrical, or ellipsoidal or non-cylindrical shaped cavity of the reactor.

Recent MPCVD reactors are designed by choosing at least a resonance mode, a coupling system, a dielectric element and the dimension of the cavity. Reactors of prior art are all designed to coat disc shaped surfaces. For example Document US 20140230729 A1 describes a microwave plasma reactor for manufacturing synthetic diamond. The reactor described in US 20140230729 A1 uses a TM011 resonant mode and provides a spherical shaped plasma which allows coating the full surface of a disc with a thin film diamond layer. As the plasma in the reactor described in US 20140230729 A1 has a spherical shape it does not allow to deposit other shapes than a disc like shape deposition.

On the other hand, HFCVD techniques allow depositing on various large size substrates but the required thickness of the diamond to be deposited is for most applications 20-100µm. The growth rate of HFCVD techniques is about 0.3-0.5 µm/h, which is absolutely not acceptable for large capacity production of diamond thin films which have a thickness of tens of microns. With a single reactor it would take some weeks to realize some wafers having a diamond thickness of 20-100 µm.

There is a growing demand for processes and reactors that would allow realizing 20-100µm thick diamond films on surfaces such as silicon carbide that have an annular shape and which have an exterior diameter of 300-400 mm. One application is for example for rotary seals for circulation pumps in industrial machines. Another application is focus rings in semiconductor etching machines. Due to the highly reactive environment of such machines existing rings are rapidly damaged by the reactive gases in such an environment.

None of the available reactors or methods allows realizing in a cost effective way films of diamond having a thickness of about 20-100 µm on an annular shaped substrate having an outside diameter of 300-400mm. Existing MPCVD reactors are limited to diameters of about 150mm and the deposition by HFCVD reactors is too slow. None of the methods or devices of prior art are capable of realizing an annular shaped synthetic diamond film in a cost effective industrial way.

### Summary of the invention

A method for producing synthetic material on a substrate by microwave plasma activated chemical vapor deposition, comprising the steps of:
- Providing a microwave plasma reactor comprising a plasma chamber with a substrate holder therein, said plasma chamber and substrate holder being configured to produce a plasma having a toroidal shape, the substrate holder being arranged to hold an annular shaped substrate or a plurality of substrates arranged in an annular arrangement, said substrate holder being parallel and facing said plasma, said reactor comprising a microwave generator configured to generate microwaves at a frequency f, the substrate holder having a first surface adapted to hold a substrate;
- Introducing a substrate or a plurality of substrates arranged in a ring, into the plasma chamber of the reactor and adapting said substrate or plurality of substrates on said substrate holder;
- Introducing process gases into said plasma chamber, the process gases comprising at least hydrogen and a carbon precursor; and
- Generating microwaves into the plasma chamber to activate the process gases and form said plasma having a toroidal shape aligned and proximate to said annular substrate whereupon a ring of synthetic material is grown over the growth surface of the substrate.

In an embodiment the shape of the substrate is a ring. The shape of the substrate may also be a disc or a plate.

In an embodiment of the method the plasma chamber defines a resonance cavity having a height H, as measured from a base plate to a top plate of the plasma chamber, which supports a resonant mode between the base and the top plate at said frequency f, so that the resonant mode, when the reactor is in operation, provides a plasma having a toroidal shape and that this shape remains stable during the operation of the reactor.

In an embodiment of the method the width of the ring of material is smaller than the width of the annular substrate, said width begin defined respectively in the plane of said hard material and said substrate.

In an embodiment of the method the material is chosen among Diamond (C), SiC, CN, B4C or a combination of them.

In an embodiment of the method the material of the substrate is chosen among Si, SiC, Si3N4, silicon derivatives, diamond, CB, CN, refractory metals and their derivatives, titanium and titanium-based alloys, cemented carbides, ceramics, oxides such as fused silica or alumina or a combination of them.

In an embodiment of the method the material of the substrate is made of any material covered with a thin layer of another material chosen among Si, SiC, Si3N4, silicon derivatives, diamond, CB, CN, refractory metals and their derivatives, titanium and titanium-based alloys, cemented carbides, ceramics, oxides such as fused silica or alumina or a combination of them.

In an embodiment of the method wherein the substrate has an annular shape and the cross section of the tube of the toroidal plasma is larger than the width of the annulus of the annular substrate, said width being defined in the plane of said substrate. In an embodiment of the method the external diameter of said annular substrate is greater than 100mm.

The deposition speed of the deposited synthetic material, defined as the deposited thickness per hour, is greater than 0.1 µm/h.

In embodiments the growth rate is typically between 0.1µm/h to 50µm/h and preferably between 1 µm/h to 10 µm/h.

In an embodiment of the method the reactor operates at a microwave frequency f in the range of 350 MHz to 500MHz, or between 800MHz and 1000MHz, or between 2300MHz and 2600MHz, or between 5000MHz and 6000MHz.

In an embodiment a second substrate holder is arranged in the resonant cavity and comprises a second surface adapted to hold a second substrate, said first surface and said second surface facing each other, and the toroidal plasma being located, in operation of the reactor, between said first and second surface.

In an embodiment of the method the resonance cavity has a diameter D and the ratio of the diameter D to the height H of the resonance cavity of the reactor is chosen so as to provide and sustain a toroidal plasma in the resonance cavity.

The invention is also achieved by a microwave plasma reactor for manufacturing synthetic material via chemical vapor deposition, the microwave plasma reactor comprising:
- a plasma chamber comprising a base, a top plate and a side wall extending from said base to said top plate defining a resonance cavity for supporting a microwave resonance mode;
- a microwave generator configured to generate microwaves at a frequency f;
- a microwave antenna, arranged to couple microwaves from said generator into the plasma chamber;
- a gas flow system for feeding process gases into the plasma chamber and removing them therefrom;
- a substrate holder;
- at least one dielectric element;
- a microwave coupling configuration for feeding microwaves from the microwave generator into the plasma chamber,
wherein:
- said plasma chamber is configured to generate a plasma having a toroidal shape, such that an annular cross-section of said plasma is parallel to an annular substrate , or parallel to a plurality of substrates arranged on a circle on said substrate holder.;
- Said substrate holder is arranged to hold a substrate or a plurality of substrates arranged in an annular arrangement, said substrate holder being parallel and facing said plasma.

In an embodiment the resonance cavity is configured to have a height H, as measured from the base to the top plate of the plasma chamber, and a diameter D, which supports a resonant mode between the base and the top plate at said frequency f.

In an embodiment the reactor operates at a microwave frequency f in the range of 350 MHz to 500MHz, or between 800MHz and 1000MHz, or between 2300MHz and 2600MHz, or between 5000MHz and 6000MHz.

In an embodiment the ratio of the diameter D and the height H of the resonance cavity of the microwave plasma reactor is adapted to provide and sustain, in operation, a plasma having a toroidal shape.

### Brief description of the drawings

Figure 1 shows a vertical cross-sectional view of a microwave plasma reactor in operation and configured to deposit annular shaped synthetic hard material using a chemical vapor deposition technique.
Figure 2 shows a cross sectional view of a microwave plasma reactor in operation, in a plane of the torus of the plasma parallel to the substrate holder of the reactor.
Figure 3 shows a vertical cross sectional view of yet another microwave plasma reactor configured to deposit an annular shaped thin film of hard material on two substrates, each substrate being located in front of a side of the plasma having a toroidal shape, using a chemical vapor deposition technique in accordance with an embodiment of the present invention.

### Detailed description of certain embodiments

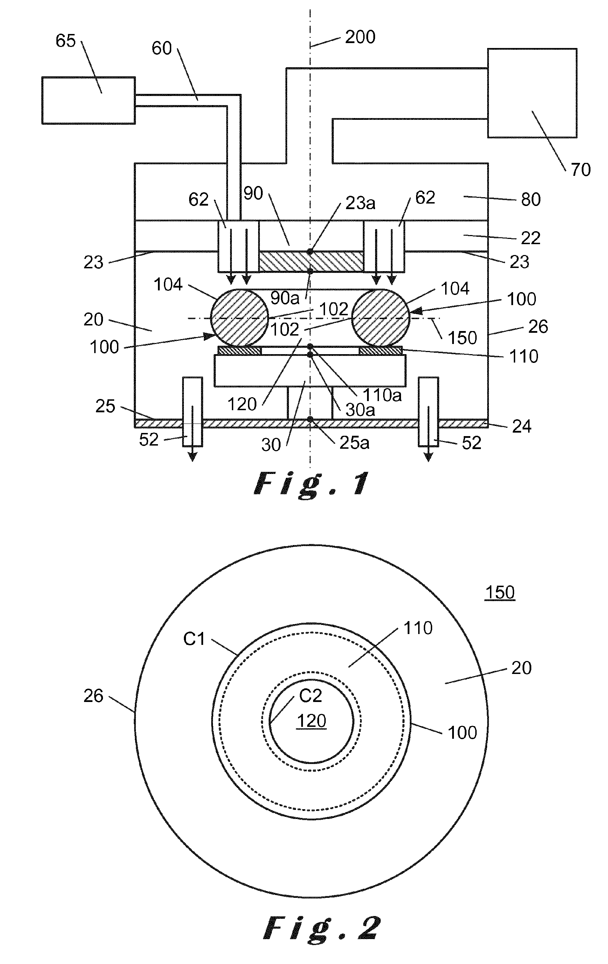

Figures 1 to 3 show various views of a microwave plasma reactor, also defined as plasma reactor or reactor, according to an embodiment of the present invention.

As can be seen by reference to Figure 1, the microwave plasma reactor comprises the following basic components:
- a plasma chamber 20, also defined as plasma cavity or resonance cavity or cavity, comprising;
   - a top plate 22;
   - a bottom plate, defined as base 24;
   - a side wall 26;
   - a substrate holder 30 disposed in the plasma chamber 20 for holding a substrate 110 having a growth surface 112 ;
- a microwave generator 70, also defined as microwave source or source , for forming a plasma 100 having a toroidal shape within the plasma chamber 20 ;
- a microwave coupling configuration 80, also defined as microwave coupling system, for feeding microwaves from the source into the plasma chamber 20 via preferably a coaxial guide, or tube, and through a dielectric window 90; The microwave coupling configuration 80 comprises an antenna;
- a gas reservoir 65 connected to a gas flow distribution system 60, comprising gas inlets 62, for feeding process gases into the plasma chamber 20 ;
- a gas outlet system, which comprises a pump and gas outlets 52, to remove process gases from said plasma chamber 20 ;

In a variant of the reactor the extremity if the antenna may be positioned into said plasma chamber 20.

Preferably the plasma reactor comprises a substrate thermostatic system, allowing cooling or heating, for controlling the temperature of a substrate. Different configurations of this thermo-regulated system are possible and are not represented in the Figures.

It is understood here that the wording plasma 100 means the plasma having a toroidal shape provided by the reactor when the reactor is in operation. The plasma has a central plane 150, parallel to the substrate holder 30, and has a center 100a as illustrated in Fig.1

It has been found that this invention is best utilized in conjunction with modal synthesis chambers that allow sustaining a plasma 100 having a toroidal shape, also defined as toroidal plasma or plasma.

The wording toroidal shape comprises any shape of a plasma 100 which has a central portion 120, defined in a plane parallel to the substrate holder 30, which is not provided with plasma 100, such as a tubular shaped plasma which central cylindrical portion does not comprise plasma. The plasma torus may have, in any plane perpendicular to the substrate holder 30, the shape of a ring torus or the shape of a horn torus or the shape of a spindle torus. The cross section of the plasma torus, in any plane perpendicular to the substrate holder, must not necessarily have a circular shape but may have an elliptical shape or a shape defined by a polynomial function.

Preferably the shape of the plasma in its central plane 150 is defined by two concentric circles C1 and C2 defining a major axis R1 and a minor axis R2 of the torus as illustrated in Fig. 1 and Fig.2. Preferably the cross section of the outer 104 and inner 102 surface of the torus, defined in a plane comprising the central axis 200, are half circles, but not necessarily so. For example, the cross section of the outer 104 and inner 102 surface of the torus, defined in a plane comprising the central axis 200, may be defined by a portion of an ellipse.

The cross section of the plasma 100, defined in any plane parallel to said substrate holder 30 may have any shape, preferably a ring type shape but other shapes are possible such as a flattened ring. More precisely, the inner border 102 and the outer border 104, may each be defined by a polynomial function. Preferably the shape of the inner border 102 and the outer border 104 is a circle or an ellipse. The shape of the outer border 104 of any cross section of the plasma, defined in any plane parallel to said substrate holder 30, may be different to the shape of the inner border 102 of the plasma in said plane. For example, the outer plasma border 102 may have an elliptical shape and the inner plasma border 104 may be substantially circular in any plane parallel to the substrate holder 30.

The plasma reactor has a base plate, also defined as base 24 comprising a reactor bottom surface, defined as the bottom surface 25 having a center 25a. The reactor also has a top plate 22 having a reactor upper surface, defined as the upper surface 23 having a center 23a. The line comprising said centers 23a and 25a defines a central axis 200 of the reactor, defining a vertical direction of the plasma reactor. Perpendicular to said central axis 200 are defined horizontal planes being parallel to the substrate holder 30.

In a preferred embodiment, the resonance cavity is configured to have a height H, as measured from said bottom surface 25 to said upper surface 23 of the plasma chamber, which supports a resonant mode between the base and the top plate at a microwave frequency f, so that a plasma having a toroidal shape may be provided by the resonant plasma chamber and so that the toroidal plasma remains stable during the operation of the reactor.

In an embodiment the reactor operates at a microwave frequency f in the range of 350 MHz to 500MHz, or between 800MHz and 1000MHz, or between 2300MHz and 2600MHz, or between 5000MHz and 6000MHz.

In an embodiment the ratio of the diameter D and the height of the plasma chamber of the microwave plasma reactor is chosen to provide and sustain a plasma having a stable toroidal shape during the operation of the reactor.

In an embodiment the plasma reactor has a cylindrically shaped cavity, but other shapes, for example a reactor cross section defined by a polynome in any horizontal plane of the reactor are also possible.

In variants of the invention different resonant modes may be used to provide a plasma having a toroidal shape.

The dielectric window 90 is preferably a disc shaped dielectric element arranged parallel to the top plate 22 and facing the center 23a of the upper surface 23, but not necessarily so. The center 90a of the dielectric window may be decentered relative to the center 23a. The same is valid for the substrate holder 30 and the substrate 110. Preferably the center 30a of the substrate holder and the center 110a of the substrate 110 are aligned on said central axis 200, but not necessarily so. The dielectric can also have an annular shape, a conical shape, a tubular shape or any other suitable shapes.

In a variant at least one of the center 110a of the substrate 110, the center 90a of the dielectric window 90, the center 23a of the upper surface 23, the center of the substrate holder, is not located on said central axis 200.

In an embodiment, in operation, the toroidal plasma 100 may be decentered relative to said central axis 200 and/or the center 110 a of the substrate 110 and/or the center 30a of the substrate holder 30, and/or the center 90a of the dielectric element, said decentering being understood as relative to a vertical direction through the concerned center 110a, 30a, 110a.

In an embodiment, the substrate holder 30 may comprise a plurality of substrate holders arranged in an annular configuration facing said plasma when the reactor is in operation. Preferably the plurality of substrate holders are aligned symmetrically relative to said central axis 200. On at least one of said plurality of substrate holders a substrate 110 to be coated may be adapted.

More generally, the wording substrate holder 30 comprises any type of substrate holder 30 or plurality of substrate holders 30 that allow to adapt at least one object, defined as substrate 110, on a ring shaped surface portion of said substrate holder 30 being parallel and facing the toroidal plasma when the reactor is in operation. The substrates 110 have a surface 110a that may be coated by a hard material and that faces said plasma 100 when the reactor is in operation.

In a variant, a plurality of substrates 110 to be coated may be arranged on a single substrate holder 110 which has a disc shape.

In the preferred embodiment of Figure 1 the gas inlets 62 are oriented parallel to said central axis 200.

In a variant the gas inlets 62 may have a different orientation. In a variant a plurality of gas inlets 62 may be provided in the plasma reactor and each of said plurality of gas inlets 62 may have different orientations relative to said central axis 200.

In another variant, gas inlets 62 may be arranged and oriented in at least one horizontal plane of the plasma reactor.

Similarly, the gas outlets 52 are preferably situated in the lower part of the plasma reactor as illustrated in Figure 1. In a variant the gas outlets 52 may have a different orientation.

In a variant, a plurality of gas outlets 52 may be provided in the plasma reactor and each of said plurality of gas outlets 52 may have different orientations relative to said vertical axis 200. In a variant, gas outlets 52 may be arranged and oriented in a horizontal plane of the plasma reactor.

In an embodiment, the microwave coupling system 80 may has a particular configuration able to shape and maintain the toroidal shape of the plasma. The same holds for the dielectric window which may be configured to shape and /or stabilize the toroidal plasma. For example the microwave coupling system 80 may comprise an antenna which extremity, positioned inside the resonance cavity, has a particular shape that allows shaping and stabilizing the annular plasma when the reactor is in operation. Said particular shape may be for example a spherical or a cylindrical or a tubular or a conical shape.

In an embodiment additional conducting or dielectric elements may be positioned in the plasma reactor 20, for example to the side wall 26 of the plasma reactor. Said additional elements may serve to shape and stabilize the toroidal shaped plasma when the reactor is in operation. The plasma reactor has a cylindrical shape but this is not necessary so. The cross section of the plasma reactor in any horizontal plane may have any shape defined by a polynomial function.

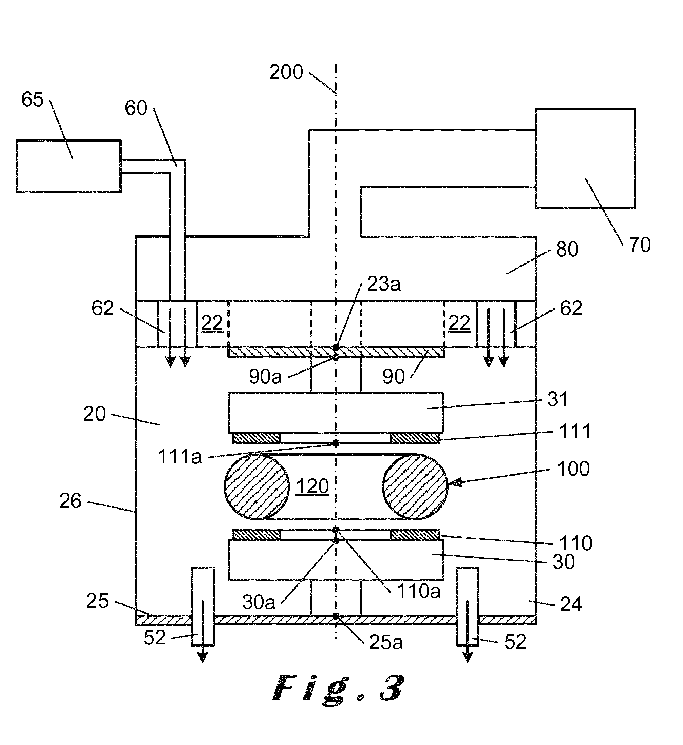

In an embodiment the reactor is configured to coat, in operation, two substrates 110,111, each of the substrates being positioned and held to opposite sides of said plasma 100, as illustrated in Fig.3. This may be realized for example by clamping each of the substrates 110,111 on a side of a substrate holder 30 having an upper portion comprising an upper surface and a lower portion comprising a lower surface, said upper and lower surface being arranged to adapt each a substrate. In this embodiment, not shown in a figure, the plasma is situated in between said lower and upper surface, said upper and lower portion being mechanically connected by a central element that passes through the central portion 120 of the plasma. This embodiment allows realizing the simultaneous coating of two ring shaped substrates.

In an embodiment, illustrated in Fig.3, at least two separate parallel substrate holders 30, 31 may be configured in the reactor, so that in operation a toroidal plasma is facing each of said substrate holders 30, 31. This configuration also allows coating at least 2 substrates 110,111 arranged on both sides of the toroidal plasma 100.

In an embodiment the reactor may be arranged to produce, in operation, at least two plasmas having a toroidal shape, each toroidal plasma having a different outer diameter and each plasma having the same symmetry center defined in a plane parallel to said substrate holder 30. This embodiment allows coating at least two ring shaped substrates having a different diameter.

In a variant said symmetry center of the at least two toroidal plasmas is different.

In variants the two toroidal plasmas may be concentric and situated in one plane or the two toroidal plasmas may be parallel.

It is understood also that the substrate holder 30 may be configured to adapt a plurality of substrates so that on each of said plurality of substrates an annular sector, i.e. having an arc shape, a hard material coating may be deposited by the reactor.

It is understood that in all the embodiments of the invention the deposition rate of the deposited synthetic material on a substrate, defined as the deposited thickness per hour, is greater than 0.1 µm/h.

The growth rate is typically between 0.1µm/h to 50µm/h and preferably between 1 µm/h to 10 µm/h.

In an embodiment a plasma configuration element is arranged on at least one side of the substrate holder. This plasma configuration element may be for example a dielectric or metallic cylinder or rod arranged perpendicular to said substrate holder and allows assuring that the inner portion 120 of the toroidal plasma has not plasma when the reactor is in operation.

In an embodiment the reactor may be configured and comprise modulation means so that said plasma has amplitude modulated portions that have a rotation in a plane parallel to the substrate holder, said amplitude being defined in the direction of the central axis 200.

In an embodiment the reactor comprises at least two microwave generators, associated each with a microwave coupling configuration and a microwave antenna. Using at least a second microwave generator and microwave antenna allows adapting the shape of the plasma, for example it allows widening and/or flattening the plasma. In an embodiment at least one of a plurality of microwave antennas may be positioned in a horizontal plane in the resonance cavity 20.

The invention is also achieved by a method to realize an annular shaped thin film of a hard coating, preferably an annular diamond coating.

More precisely the invention provides a method for producing synthetic material on a substrate by microwave plasma activated chemical vapor deposition, comprising the steps of:
- Providing a microwave plasma reactor, as described before, comprising a plasma chamber 20 with a substrate holder 30 therein, said plasma chamber and substrate holder 30 being configured to produce a plasma having a toroidal shape, the substrate holder 30 being arranged to hold a substrate 110 or a plurality of substrates 110 arranged in an annular arrangement, said substrate holder 30 being parallel and facing said plasma, said reactor comprising a microwave generator 70 configured to generate microwaves at a frequency f;
- Introducing a substrate 110, or a plurality of substrates 110 arranged in a ring, into the plasma chamber of the reactor and adapting said substrate 110 or plurality of substrates 110 on said substrate holder 30. The substrate 110, or the plurality of substrate 110, may be placed on said substrate holder 30 without using fixing means or may be clamped to the substrate holder 30 or put in place to the substrate holder 30 by any other means, such as magnetic or electric means.

- Introducing process gases into said plasma chamber 20, the process gases comprising at least hydrogen and a carbon precursor; and
- Introducing microwaves into the plasma chamber 20 to activate the process gases and form said plasma having a toroidal shape aligned and proximate to said substrate 110 whereupon a ring of synthetic material is grown over the growth surface 112 of the substrate 110.

In an embodiment the substrate is a ring shaped substrate. The substrate may also be a plate or a disc or may have any other shape, even a curved shape.

In an embodiment of the method the plasma chamber 20 defines a resonance cavity having a height H, as measured from a base plate to a top plate of the plasma chamber, which supports preferably a resonant mode between the base and the top plate at said frequency f, so that a toroidal plasma may be provided by the reactor and assuring that the shape of the plasma remains stable during the coating process.

It is generally understood that in variants, means may be provided to change the shape of the plasma during operation of the plasma. For example, during the coating process the dimension of the plasma in the vertical direction or in any horizontal plane may be varied. In a variant, the shape of the plasma may be varied during the coating process. For example the plasma may have a torus shape at the start of the coating process and have a flattened torus shape at the end of the coating process.

In an embodiment of the method the width of the ring of material may be smaller than the width of the annular substrate, said width begin defined respectively in the plane of said hard material and said substrate.

In an embodiment of the method, if the substrate has an annular shape, the width of the annulus of the torus of the plasma, defined in the central plane 150, may be greater than the width w of the annulus of the substrate, as illustrated in Fig.1.

In a variant of the method, if the substrate has an annular shape, the width of the annulus of the torus of the plasma, defined in the central plane 150 , may be smaller than the width w of the annulus of the substrate.

In an embodiment of the method the material is chosen among Diamond (C), SiC, CN, B4C or a combination of them.

In an embodiment of the method the material of the substrate is chosen among Si, SiC, Si3N4, silicone derivatives, diamond, CB, CN, refractory metals and their derivatives, titanium and titanium-based alloys, cemented carbides, ceramics, oxides such as fused silica or alumina or a combination of them.

In an embodiment of the method the cross section of the toroidal plasma is larger than the width of the annular substrate, said width being defined in the plane of said substrate

In an embodiment of the method the external diameter of said annular substrate is greater than 100mm.

In an embodiment of the method the deposition speed of the deposited synthetic material, defined as the deposited thickness per hour, is greater than 0.1 µm/h.

In an embodiment of the method the reactor operates at a microwave frequency f in the range of 350 MHz to 500MHz, or between 800MHz and 1000MHz, or between 2300MHz and 2600MHz, or between 5000MHz and 6000MHz.

In an embodiment the ratio of the diameter D and the height H of the plasma chamber 20 of the reactor is chosen to provide, in operation, a stable toroidal plasma in the resonant cavity 20.

It is understood that the reactor may comprise further parts or configurations that allow modifying the shape or dimensions of the deposited thin film of hard material. For example the reactor may be configured, so that after the deposition of the hard annular coating, a portion of the deposited thin film of hard material may be etched. This may allow for example to manufacture an annular shaped thin film of diamond having annular sectors that have different thicknesses. Another example is to provide means in the reactor so that apertures may be realized in the annular deposited thin film of hard material.

Also, additional coating means may be provided in the reactor to enable to coat the deposited annular thin film of hard material with a further thin film, for example the deposition of an anti-reflection layer.

## Claims

1. A method for producing synthetic material on a substrate by microwave plasma activated chemical vapor deposition, comprising the steps of:
- Providing a microwave plasma reactor comprising a plasma chamber (20) with a substrate holder (30) therein, said plasma chamber (20) and substrate holder (30) being configured to produce a plasma (100) having a toroidal shape, the substrate holder (30) being arranged to hold a substrate (110) or a plurality of substrates, said substrate holder (30) being parallel and facing said plasma, said reactor comprising a microwave generator (70) configured to generate microwaves at a frequency f;
- Placing a substrate (110), or a plurality of substrates, into the plasma chamber 20 on said substrate holder (30);
- Generating a plasma by introducing process gases into said plasma chamber (20), the process gases comprising at least hydrogen and a carbon precursor; and
- Generating microwaves into the plasma chamber to activate the process gases and form said plasma having a toroidal shape aligned and proximate to said substrate whereupon a ring of synthetic material is grown over the growth surface (110a) of the substrate (110).

2. Method according to claim 1 wherein the shape of the substrate (110) is a ring.

3. Method according to claim 1 or 2 wherein the substrate is a plurality of substrates arranged in an annular arrangement.

4. Method according to any one of claims 1 or 3, wherein the plasma chamber (20) defines a resonance cavity having a height H, as measured from a base plate to a top plate of the plasma chamber, which supports a resonant mode between the base (24) and the top plate (22) at said frequency f so that said resonant mode provides an plasma having a toroidal shape when the reactor is in operation.

5. Method according to any one of claims 1 to 4, wherein the material is chosen among Diamond (C), SiC, CN, B4C or a combination of them.

6. Method according to any one of claims 1 to 5, wherein the material of the substrate is chosen among Si, SiC, Si3N4, silicon derivatives, diamond, CB, CN, refractory metals and their derivatives, titanium and titanium-based alloys, cemented carbides, ceramics, oxides such as fused silica or alumina or a combination of them.

7. Method according to any one of claims 1 to 6, wherein the material of the substrate is made of any material covered with a thin layer of another material chosen among Si, SiC, Si3N4, silicon derivatives, diamond, CB, CN, refractory metals and their derivatives, titanium and titanium-based alloys, cemented carbides, ceramics, oxides such as fused silica or alumina or a combination of them.

8. Method according to any one of claims 1 to 7, wherein the substrate has an annular shape and the cross section of the tube of the toroidal plasma is larger than the width of the annulus of the annular substrate (110), said width being defined in the plane of said substrate (110).

9. Method according to any one of claims 1 to 8, wherein a larger dimension of said substrate (110) is greater than 100 mm.

10. Method according to any one of claims 1 to 9, wherein the growth rate of the deposited synthetic material, defined as the deposited thickness per hour, is greater than 0.1 µm/h.

11. Method according to claim 10 wherein the growth rate is between 0.1µm/h to 50µm/h, preferably between 1 µm/h to 10 µm/h.

12. Method according to one of claims 1 to 11, wherein the reactor operates at a microwave frequency f in the range of 350 MHz to 500MHz, or between 800MHz and 1000MHz, or between 2300MHz and 2600MHz, or between 5000MHz and 6000MHz.

13. Method according to any one of claims 1 to 12, wherein a second substrate holder (31) faces said substrate holder (30), the toroidal shaped plasma (100) being formed between said first (30) and second (31) substrate holder when the reactor is in operation, said first and second substrate holder (30,31) being each arranged to hold a substrate (110, 111) to the side of said plasma (100).

14. Method according to one of claims 1 to 13, wherein the resonance cavity (20) has a diameter D, and the ratio of the diameter D to the height H of the resonance cavity (20) of the reactor is adapted to provide and sustain, in operation, a plasma having a toroidal shape

15. A microwave plasma reactor for manufacturing synthetic material via chemical vapor deposition, the microwave plasma reactor comprising:
- a plasma chamber (20) comprising a base (24), a top plate (22) and a side wall (26) extending from said base (24) to said top plate (22) defining a resonance cavity for supporting a microwave resonance mode;
- a microwave generator (70) configured to generate microwaves at a frequency f;
- a microwave antenna, arranged to couple microwaves from said generator (70) into the plasma chamber (20);
- a gas flow system for feeding process gases into the plasma chamber (20) and removing them therefrom;
- a substrate holder (30);
- a microwave coupling configuration (80) for feeding microwaves from the microwave generator into the plasma chamber;
- at least one dielectric element (90),
wherein:
- said plasma chamber (20) is configured to generate a plasma (100) having a toroidal shape, such that an annular cross-section of said plasma (100) is parallel to a substrate (110) or parallel to a plurality of substrates arranged in an annular arrangement on said substrate holder (30);
- said substrate holder (30) is arranged to hold a substrate which can be a ring, a disc, a plate, or a plurality of substrates, preferably arranged in an annular arrangement, said substrate holder (30) being parallel and facing said plasma (100) when the reactor is in operation,;

16. The microwave plasma reactor according to claim 15 wherein the resonance cavity (20) is configured to have a height H, as measured from the base to the top plate of the plasma chamber, and a diameter D, which supports a resonant mode between the base (24) and the top plate (22) at said frequency f, so that a plasma having a toroidal shape may be provided and maintained in the resonant cavity (20).

17. The microwave plasma reactor according to one of claims 15 or 16, wherein the reactor operates at a microwave frequency f in the range of 350 MHz to 500MHz, or between 800MHz and 1000MHz, or between 2300MHz and 2600MHz, or between 5000MHz and 6000MHz.

18. The microwave plasma reactor according to one of claims 15 to 17 , wherein the ratio of the diameter D and the height H of the resonance cavity (20) of the microwave plasma reactor is chosen so that a plasma having a toroidal shape may be provided and maintained in the resonant cavity (20).
